# EUROPEAN PATENT APPLICATION

(11) **EP 4 679 951 A1**
(43) Date of publication of application: **14.01.2026**
(21) Application number: 25186420.3
(22) Date of filing: 30.06.2025
(51) Int. Cl.: H05K 7/14

(54) **CONTROLLER**

(30) Priority: 08.07.2024 JP 2024109859
(71) Applicant: Seiko Epson Corporation, Tokyo 160-8801 (JP)
(72) Inventor: KITAHARA, Yuta, Suwa-shi, Nagano, 392-8502 (JP); OKUBO, Yuta, Suwa-shi, Nagano, 392-8502 (JP)
(74) Representative: MERH-IP Matias Erny Reichl Hoffmann Patentanwälte PartG mbB

(57) **Abstract**

A controller includes a housing including a bottom surface panel, a power supply circuit substrate including a first connector, disposed on the bottom surface panel, a system circuit substrate including a second connector, disposed on the bottom surface panel by being aligned with the power supply circuit substrate in a direction along the bottom surface panel, and a first cable coupled to the first connector and the second connector. The first connector is disposed along a side of the power supply circuit substrate which faces the system circuit substrate. The second connector is disposed along a side of the system circuit substrate which faces the power supply circuit substrate. The first connector and the second connector are disposed to be shifted in a second direction orthogonal to a first direction in which the power supply circuit substrate and the system circuit substrate are aligned.

## Description

The present application is based on, and claims priority from JP Application Serial Number 2024-109859, filed July 8, 2024, the disclosure of which is hereby incorporated by reference herein in its entirety.

### BACKGROUND

### 1. Technical Field

The present disclosure relates to a controller.

### 2. Related Art

A motor control device as an electronic device disclosed in JP-A-2021-088057 includes a first circuit substrate and a second circuit substrate disposed to overlap the first circuit substrate. In addition, a connector disposed on the first circuit substrate and a connector disposed on the second circuit substrate are coupled via a cable.

In this way, JP-A-2021-088057 discloses that the connector on the first circuit substrate and the connector on the second circuit substrate are coupled via the cable. However, it is not clear which connector on the first circuit substrate and which connector on the second circuit substrate are coupled. Therefore, depending on a disposition of the connectors coupled to each other, there is a possibility that the assembly workability and the maintenance workability of the motor control device deteriorate.

### SUMMARY

According to an aspect of the present disclosure, there is provided a controller that controls driving of a robot on which a motor is mounted. The controller includes a housing including a bottom surface panel, a power supply circuit substrate including a first connector, disposed on the bottom surface panel, converting an AC voltage into a DC voltage, and outputting the DC voltage, a system circuit substrate including a second connector, disposed on the bottom surface panel by being aligned with the power supply circuit substrate in a direction along the bottom surface panel, driven by the DC voltage input from the power supply circuit substrate, and generating a control signal for controlling driving of the motor, and a first cable coupled to the first connector and the second connector and electrically coupling the power supply circuit substrate and the system circuit substrate. The first connector is disposed along a side of the power supply circuit substrate which faces the system circuit substrate. The second connector is disposed along a side of the system circuit substrate which faces the power supply circuit substrate. The first connector and the second connector are disposed to be shifted in a second direction orthogonal to a first direction in which the power supply circuit substrate and the system circuit substrate are aligned.

### BRIEF DESCRIPTION OF THE DRAWINGS

FIG. 1 is an overall view illustrating a robot system according to a preferred embodiment.
FIG. 2 is a perspective view illustrating an inside of a controller.
FIG. 3 is a plan view illustrating the inside of the controller.
FIG. 4 is a plan view for describing a disposition of connectors.

### DESCRIPTION OF EMBODIMENTS

Hereinafter, a controller of the present disclosure will be described in detail with reference to an embodiment illustrated in the accompanying drawings.

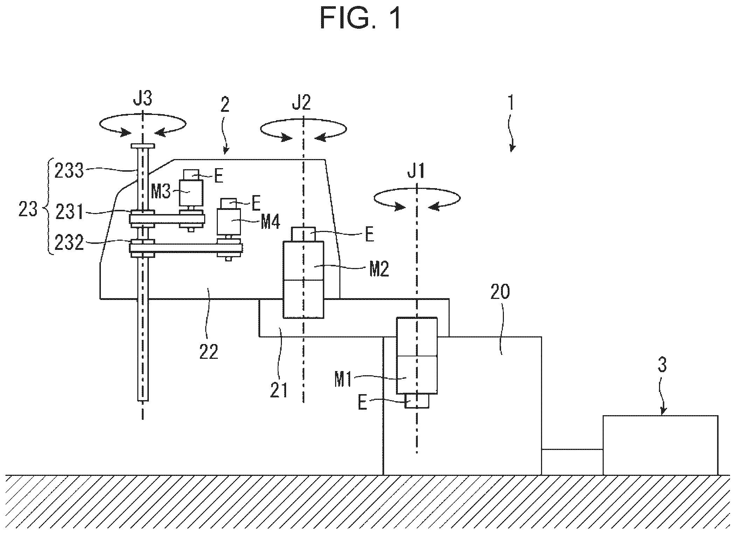

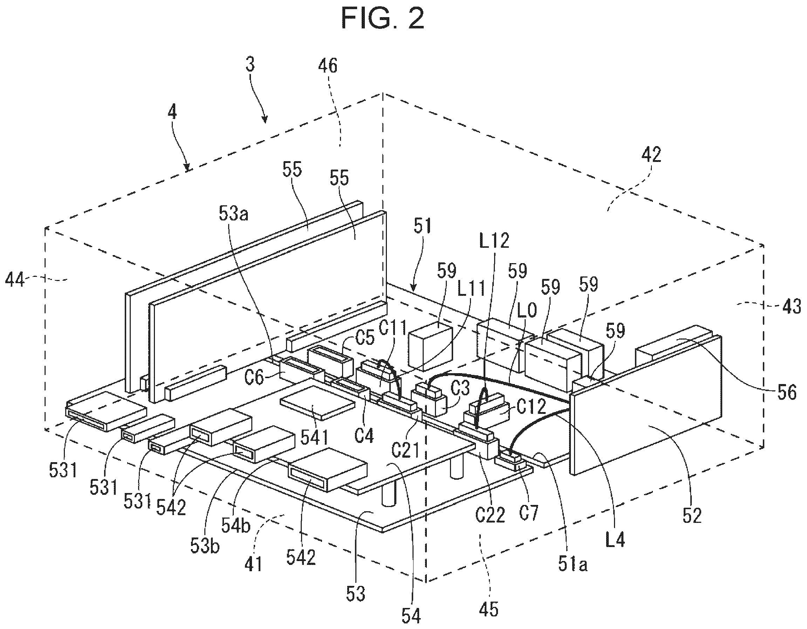

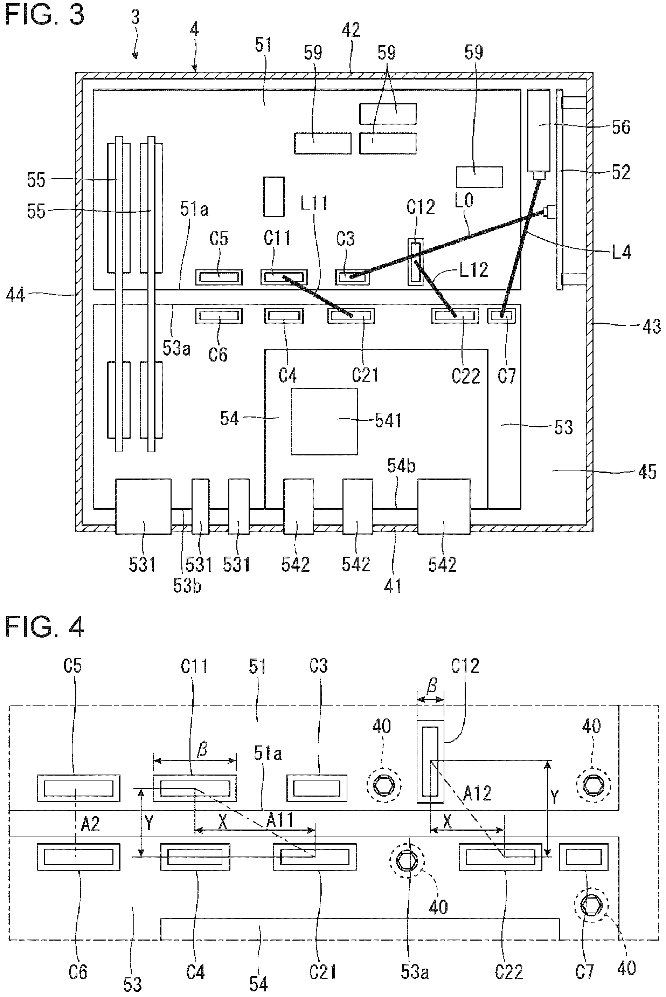

FIG. 1 is an overall view illustrating a robot system according to a preferred embodiment. FIG. 2 is a perspective view illustrating an inside of the controller. FIG. 3 is a plan view illustrating the inside of the controller. FIG. 4 is a plan view for describing a disposition of connectors.

A robot system 1 illustrated in FIG. 1 includes a robot 2 and a controller 3 for controlling driving of the robot 2.

In addition, as illustrated in FIG. 1, the robot 2 is a SCARA robot (horizontal articulated robot), and includes a base 20 fixed to a floor, a first arm 21 connected to the base 20 and pivoting around a first pivoting axis J1 along a vertical direction with respect to the base 20, a second arm 22 connected to the first arm 21 and pivoting around a second pivoting axis J2 along the vertical direction with respect to the first arm 21, and a working head 23 disposed at a tip portion of the second arm 22.

In addition, the working head 23 includes a spline nut 231 and a ball screw nut 232 which are coaxially disposed at the tip portion of the second arm 22, and a spline shaft 233 inserted into the spline nut 231 and the ball screw nut 232. Although not illustrated, an end effector corresponding to a work purpose is mounted on a lower end portion of the spline shaft 233.

In this working head 23, the spline shaft 233 pivots around a third pivoting axis J3 along the vertical direction by pivoting of the spline nut 231, and is linearly moved (raised and lowered) along the third pivoting axis J3. The spline shaft 233 is linearly moved along the third pivoting axis J3 by pivoting of the ball screw nut 232, and the spline shaft 233 pivots around the third pivoting axis J3 by pivoting of both the spline nut 231 and the ball screw nut 232.

In addition, the robot 2 includes a motor M1 causing the first arm 21 to pivot around the first pivoting axis J1 with respect to the base 20, a motor M2 causing the second arm 22 to pivot around the second pivoting axis J2 with respect to the first arm 21, a motor M3 causing the spline nut 231 to pivot, and a motor M4 causing the ball screw nut 232 to pivot. Each of the motors M1, M2, M3, and M4 is an AC motor, particularly a three-phase AC motor. In addition, an encoder E for detecting a rotation amount of a rotary shaft is incorporated in each of the motors M1, M2, M3, and M4.

Hitherto, the robot 2 has been described, but a configuration of the robot 2 is not particularly limited. For example, the robot 2 may be a 6-axis articulated robot.

For example, the controller 3 controls the robot 2 by independently driving each of the motors M1, M2, M3, and M4, based on a drive command received from a host computer (not illustrated).

As illustrated in FIG. 2, the controller 3 includes a housing 4. The housing 4 has a rectangular parallelepiped shape, and includes a rectangular frame-shaped side wall panel having a front surface panel 41, a rear surface panel 42, a first side surface panel 43, and a second side surface panel 44, a bottom surface panel 45 that closes a lower end opening of the side wall panel, and a top surface panel 46 that closes an upper end opening of the side wall panel. Among the six panels 41 to 46, at least the top surface panel 46 is detachably fixed to the other panels by screws or the like. Therefore, when the top surface panel 46 is detached, it is easy to access an inside of the housing 4, and assembling, maintenance, or the like of the controller 3 can be easily performed. However, a configuration of the housing 4 is not particularly limited.

Hereinafter, for convenience of description, a direction in which the bottom surface panel 45 and the top surface panel 46 are aligned will be referred to as a "height direction", a direction in which the front surface panel 41 and the rear surface panel 42 are aligned will be referred to as a "depth direction" which is a first direction, and a direction in which the first and second side surface panels 43 and 44 are aligned will be referred to as a "width direction" which is a second direction orthogonal to the first direction.

In addition, as illustrated in FIG. 2, the controller 3 includes a power supply circuit substrate 51, a sub-power supply circuit substrate 52, a system circuit substrate 53, a control circuit substrate 54, a motor drive substrate 55, and a fan 56 which are accommodated inside the housing 4.

For example, the power supply circuit substrate 51 and the sub-power supply circuit substrate 52 are coupled to an external power supply, and convert an AC voltage of 200 V supplied from the external power supply into a DC voltage used inside the controller 3. In addition, the control circuit substrate 54 executes an operation command program of the robot 2 which is received from a host computer (not illustrated) such as a teaching pendant, and generates a position command indicating a movement destination of the robot 2 in accordance with a target position of the robot 2 which is set in the operation command program. In addition, the system circuit substrate 53 calculates a rotation amount of each of the motors M1 to M4 which is required for moving the robot 2 to a position indicated by the position command generated by the control circuit substrate 54, and generates a voltage command for each phase of U-phase, a V-phase, and a W-phase, which corresponds to the calculated rotation amount. The motor drive substrate 55 boosts a DC voltage input from the power supply circuit substrate 51 to a DC voltage suitable for driving each of the motors M1 to M4, and converts the boosted DC voltage into a polyphase AC voltage of each of the motors M1 to M4, based on a control signal corresponding to the voltage command input from the system circuit substrate 53. The converted polyphase AC voltage is supplied to each of the motors M1 to M4. Hitherto, a function of each of the substrates 51, 52, 53, 54, and 55 has been briefly described.

However, the function of each of the substrates 51 to 55 is not particularly limited. In addition, as long as at least the power supply circuit substrate 51 and the system circuit substrate 53 are provided, the other substrates 52, 54, and 55 may be omitted, and the functions of the omitted substrates may be added to other panels.

As illustrated in FIGS. 2 and 3, the power supply circuit substrate 51 is fixed to the bottom surface panel 45. In addition, the power supply circuit substrate 51 has a posture substantially parallel to the bottom surface panel 45, and is disposed closer to the rear surface panel 42 side. In addition to a case where the power supply circuit substrate 51 is parallel to the bottom surface panel 45, the "substantially parallel" includes a case where the power supply circuit substrate 51 is inclined with respect to the bottom surface panel 45 to such an extent that components can be regarded as being parallel from a technical common sense in view of forming accuracy, assembling accuracy, or the like of the components, for example, in a range of approximately ±5° or smaller. Hereinafter, the same applies to the meaning of "substantially parallel".

In addition, as illustrated in FIGS. 2 and 3, the power supply circuit substrate 51 has a substantially rectangular shape in a plan view. In addition, on an upper surface of the power supply circuit substrate 51, first connectors C11 and C12, a third connector C3, and a fifth connector C5 are disposed along a side 51a facing the system circuit substrate 53. The fifth connector C5, the first connector C11, the third connector C3, and the first connector C12 are aligned in this order from the second side surface panel 44 side to the first side surface panel 43 side. In addition, the first, third, and fifth connectors C11, C12, C3, and C5 each have a substantially rectangular long shape in a plan view of the bottom surface panel 45, that is, in a plan view in the height direction. The first connector C11, the third connector C3, and the fifth connector C5 each extend along the side 51a, that is, along the width direction, and the first connector C12 extends along a direction orthogonal to the side 51a, that is, along the depth direction. It is desirable that the first connectors C11 and C12, the third connector C3, and the fifth connector C5 are components closest to the system circuit substrate 53 in the power supply circuit substrate 51.

In addition, as illustrated in FIGS. 2 and 3, the power supply circuit substrate 51 includes a plurality of electronic components 59 disposed on an upper surface thereof. Although not particularly limited, an example of the electronic component 59 includes a relay or the like for switching ON/OFF of a circuit. In addition, the power supply circuit substrate 51 includes a noise filter (not illustrated).

For example, the power supply circuit substrate 51 as described above uses a rectification circuit such as a diode bridge to convert an AC voltage of 200 V into a DC voltage of 280 V, and inputs the DC voltage to each motor drive substrate 55. In addition, the power supply circuit substrate 51 inputs the AC voltage of 200 V to the sub-power supply circuit substrate 52.

The sub-power supply circuit substrate 52 is fixed to the first side surface panel 43. In addition, the sub-power supply circuit substrate 52 has a posture substantially parallel to the first side surface panel 43. In addition, in a plan view in the height direction, the power supply circuit substrate 51 and the sub-power supply circuit substrate 52 are aligned in the width direction. In this way, since the sub-power supply circuit substrate 52 is disposed in an erected state from the power supply circuit substrate 51, a planar spread of the controller 3 can be suppressed, and an installation area of the controller 3 can be minimized. Therefore, the controller 3 is easily installed. However, a disposition of the sub-power supply circuit substrate 52 is not particularly limited.

The sub-power supply circuit substrate 52 is coupled to the third connector C3 of the power supply circuit substrate 51 via a cable L0. The sub-power supply circuit substrate 52 converts the AC voltage of 200 V input from the power supply circuit substrate 51 into the DC voltage of 24 V via the cable L0, and inputs the converted DC voltage to the power supply circuit substrate 51 via the cable L0. The power supply circuit substrate 51 inputs the DC voltage of 24 V input from the sub-power supply circuit substrate 52 to the system circuit substrate 53.

The system circuit substrate 53 is driven by the DC voltage of 24 V input from the power supply circuit substrate 51, and generates a control signal for controlling driving of each of the motors M1, M2, M3, and M4. In this way, since the power supply circuit substrate 51 that handles the AC voltage of 200 V and the system circuit substrate 53 that handles the DC voltage of 24 V are formed as separate substrates, crosstalk therebetween can be effectively suppressed.

In addition, as illustrated in FIGS. 2 and 3, the system circuit substrate 53 is fixed to the bottom surface panel 45. In addition, the system circuit substrate 53 has a posture substantially parallel to the bottom surface panel 45, and is disposed closer to the front surface panel 41 side. In addition, the system circuit substrate 53 is disposed at substantially the same height as the power supply circuit substrate 51, is located in front of (on the front surface panel 41 side) the power supply circuit substrate 51, and is aligned with the power supply circuit substrate 51 in the depth direction. That is, the power supply circuit substrate 51 and the system circuit substrate 53 are aligned in the depth direction in a state where the power supply circuit substrate 51 is brought closer to the rear surface panel 42 side and the system circuit substrate 53 is brought closer to the front surface panel 41 side without overlapping each other in a plan view in the height direction.

In addition, as illustrated in FIGS. 2 and 3, the system circuit substrate 53 has a substantially rectangular shape in a plan view, and has substantially the same size as the power supply circuit substrate 51. In addition, the second connectors C21 and C22, the fourth connector C4, the sixth connector C6, and the seventh connector C7 are disposed on an upper surface of the system circuit substrate 53 along a side 53a facing the power supply circuit substrate 51. The sixth connector C6, the fourth connector C4, the second connector C21, the second connector C22, and the seventh connector C7 are aligned in this order from the second side surface panel 44 side to the first side surface panel 43 side. In addition, the second, fourth, sixth, and seventh connectors C21, C22, C4, C6, and C7 each have a substantially rectangular long shape in a plan view in the height direction, and extend along the side 53a, that is, along the width direction. It is desirable that the second connectors C21 and C22, the fourth connector C4, the sixth connector C6, and the seventh connector C7 are components closest to the power supply circuit substrate 51 in the system circuit substrate 53.

The first and second connectors C11 and C21 are electrically coupled to each other via a first cable L11, and the first and second connectors C12 and C22 are electrically coupled to each other via a first cable L12. The power supply circuit substrate 51 and the system circuit substrate 53 input and output various signals including the DC voltage of 24 V via the first cables L11 and L12.

In addition, as illustrated in FIGS. 2 and 3, the system circuit substrate 53 includes a plurality of IF connectors 531. The plurality of IF connectors 531 are aligned in one row in the width direction along a side 53b on the front surface panel 41 side of the upper surface of the system circuit substrate 53, and face an outside of the controller 3 via a hole formed in the front surface panel 41. For example, the plurality of IF connectors 531 include a connector coupled to each encoder E to acquire a signal from each encoder E, a connector coupled to an end effector to acquire a signal from the end effector, a connector coupled to a peripheral device of the robot 2 to acquire a signal from the peripheral device, and the like. The number, a disposition, a function, a standard, and the like of the IF connectors 531 are not particularly limited.

The system circuit substrate 53 configured in this way converts the DC voltage of 24 V input from the power supply circuit substrate 51 into DC voltages such as 16 V, 5 V, and 3.3 V, and inputs each of the DC voltages of 24 V, 16 V, 5 V, and 3.3 V to required locations of the system circuit substrate 53, the control circuit substrate 54, and the motor drive substrate 55. In addition, as described above, the system circuit substrate 53 calculates the rotation amount of each of the motors M1 to M4 which is required for moving the robot 2 to a position indicated by the position command generated by the control circuit substrate 54, and generates a voltage command for each phase of the U-phase, the V-phase, and the W-phase, which corresponds to the calculated rotation amount for each of the motors M1 to M4.

In addition, as illustrated in FIGS. 2 and 3, the control circuit substrate 54 is located on an upper side of the system circuit substrate 53, and is fixed to the system circuit substrate 53 via a pillar. In addition, although not illustrated, the control circuit substrate 54 is electrically coupled to the system circuit substrate 53 by fitting the connector disposed on a lower surface thereof into the connector disposed on an upper surface of the system circuit substrate 53. In this way, since the connectors are directly coupled to each other, coupling work thereof is more easily carried out, compared to a case of coupling work via a cable. In particular, the connector on the system circuit substrate 53 side is a floating connector, and can absorb a mounting deviation between the system circuit substrate 53 and the control circuit substrate 54 generated during mounting. In this manner, stress is less likely to occur in the system circuit substrate 53 and the control circuit substrate 54. However, a configuration of the connector is not particularly limited.

In addition, as illustrated in FIGS. 2 and 3, the control circuit substrate 54 has a posture substantially parallel to the bottom surface panel 45, and is disposed closer to the front surface panel 41 side. In addition, the control circuit substrate 54 overlaps the system circuit substrate 53 in a plan view in the height direction, and does not overlap the power supply circuit substrate 51. In particular, in the present embodiment, the whole control circuit substrate 54 is included in the system circuit substrate 53 in a plan view in the height direction.

In addition, as illustrated in FIGS. 2 and 3, the control circuit substrate 54 is a system on a chip (SOC) including electronic components such as a CPU 541 and a memory (not illustrated). The memory stores various programs and data which are required for the controller 3 to control the driving of the robot 2, such as an operation command program. The control circuit substrate 54 is operated by a processor reading and executing data stored in the memory, an operation command program, and the like. Specifically, the control circuit substrate 54 generates a position command indicating a movement destination of the robot 2, based on a target position of the robot 2 which is set by the operation command program and an actual position of the robot 2 which is specified from a detection signal of each encoder E.

In addition, as illustrated in FIGS. 2 and 3, the control circuit substrate 54 includes a plurality of IF connectors 542. The plurality of IF connectors 542 are aligned in one row in the width direction along a side 54b on the front surface panel 41 side of the upper surface of the control circuit substrate 54, and face the outside of the controller 3 via a hole formed in the front surface panel 41. For example, the plurality of IF connectors 542 include the connector or the like to which a host computer such as a teaching pendant is coupled to acquire the operation command program. The number, a disposition, a function, a standard, and the like of the IF connectors 542 are not particularly limited.

Here, it is preferable that the number of cable coupling connectors disposed on the system circuit substrate 53 is larger than the number of cable coupling connectors disposed on the control circuit substrate 54. In addition, it is preferable that the number of cable coupling connectors disposed on the control circuit substrate 54 is 0 (zero). According to this configuration, bending deformation of the control circuit substrate 54 due to insertion and removal of the cable can be suppressed, and a contact failure or the like can be effectively suppressed.

In addition, as illustrated in FIGS. 2 and 3, two motor drive substrates 55 are disposed. Each of the motor drive substrates 55 is located on the power supply circuit substrate 51 and the system circuit substrate 53, and overlaps the power supply circuit substrate 51 and the system circuit substrate 53 in a plan view in the height direction. In addition, each of the motor drive substrates 55 is substantially parallel to the second side surface panel 44. That is, each of the motor drive substrates 55 is installed in an erected state from the power supply circuit substrate 51 and the system circuit substrate 53. In addition, the motor drive substrates 55 each are disposed closer to the second side surface panel 44 side, and are aligned in the width direction. Each of the motor drive substrates 55 is fitted to the connector disposed on the upper surface of the power supply circuit substrate 51 and the connector disposed on the upper surface of the system circuit substrate 53, and is electrically coupled to the power supply circuit substrate 51 and the system circuit substrate 53. In addition, although not illustrated, each of the motor drive substrates 55 is fixed to the housing 4 via a support beam in the vicinity of an upper end thereof.

One of the two motor drive substrates 55 generates a polyphase AC voltage for the motors M1 and M2, and the other generates a polyphase AC voltage for the motors M3 and M4. Since the two motor drive substrates 55 have the same configuration as each other, hereinafter, the motor drive substrate 55 that generates the polyphase AC voltage for the motors M1 and M2 will be described as a representative example.

Although not illustrated, a first power module for generating the polyphase AC voltage for the motor M1 and a second power module for generating the polyphase AC voltage for the motor M2 are disposed on the motor drive substrate 55.

The DC voltage of 17 V and 280 V is input to the first power module from the power supply circuit substrate 51, and each of the DC voltage of 5 V and a control signal for the motor M1 is input to the first power module from the system circuit substrate 53. The first power module is driven by the DC voltage of 5 V, and an incorporated converter boosts the DC voltage of 280 V to a voltage suitable for driving the motor M1. Furthermore, an inverter circuit including a plurality of switching elements is incorporated in the first power module, and the inverter circuit is subjected to ON/OFF control by the control signal for the motor M1 which is input from the system circuit substrate 53. In this manner, the voltage boosted by the converter is converted into the polyphase AC voltage (three-phase AC voltage) for the motor M1. In this way, the polyphase AC voltage generated by the first power module is output to the motor M1.

Similarly, the DC voltage of 280 V is input to the second power module from the power supply circuit substrate 51, and each of the DC voltage of 5 V and a control signal for the motor M2 is input to the second power module from the system circuit substrate 53. The second power module is driven by the DC voltage of 5 V, and the incorporated converter boosts the DC voltage of 280 V to a voltage suitable for driving the motor M2. Furthermore, an inverter circuit including a plurality of switching elements is incorporated in the second power module, and the inverter circuit is subjected to ON/OFF control by the control signal for the motor M2 which is input from the system circuit substrate 53. In this manner, the voltage boosted by the converter is converted into the polyphase AC voltage (three-phase AC voltage) for the motor M2. In this way, the polyphase AC voltage generated by the second power module is output to the motor M2.

In addition, as illustrated in FIGS. 2 and 3, a fan 56 is disposed in an erected posture between the power supply circuit substrate 51 and the sub-power supply circuit substrate 52 in a plan view in the height direction, and blows air to the second side surface panel 44 side (power supply circuit substrate 51 side). In this manner, the power supply circuit substrate 51 and a regenerative resistor (not illustrated) attached to the rear surface panel 42 of the housing 4 can be effectively cooled. In addition, the fan 56 is electrically coupled to the seventh connector C7 via a cable L4, and driving of the fan 56 is controlled, based on a signal from the system circuit substrate 53.

Hitherto, an overall configuration of the controller 3 has been described. Next, referring to FIG. 4, the disposition of the first, third, and fifth connectors C11, C12, C3, and C5 which are disposed on the power supply circuit substrate 51 and the second, fourth, sixth, and seventh connectors C21, C22, C4, C6, and C7 which are disposed on the system circuit substrate 53 will be described in detail.

The first, second, third, fourth, fifth, sixth, and seventh connectors C11, C12, C21, C22, C3, C4, C5, C6, and C7 are intensively disposed in the vicinity of a center of the controller 3. Therefore, it is easy to secure a work space (space into which a human hand or a hand of an assembly robot is inserted) around the first, second, third, fourth, fifth, sixth, and seventh connectors C11, C12, C21, C22, C3, C4, C5, C6, and C7. As a result, a cable can be easily inserted into and removed from the first, second, third, fourth, fifth, sixth, and seventh connectors C11, C12, C21, C22, C3, C4, C5, C6, and C7, and assembly workability and maintenance workability of the controller 3 are improved.

In addition, the first and second connectors C11 and C21 which are coupled to each other by the first cable L11 are disposed to be shifted in the width direction in a plan view in the height direction. In other words, the first and second connectors C11 and C21 do not overlap each other in a plan view in the depth direction. In this way, since the first and second connectors C11 and C21 are disposed to be shifted in the width direction, the assembly workability and the maintenance workability of the controller 3 are improved.

When this advantageous effect is described in detail, and when the first and second connectors C11 and C21 are disposed to face each other in the depth direction, a separation distance between the first and second connectors C11 and C21 is shorter than a separation distance in the present embodiment. Therefore, it is conceivable that a total length of the first cable L11 can be shortened that much. However, in general, it is necessary to set a bending radius of the cable to be equal to or larger than 6 times a diameter of the cable. Therefore, the total length of the first cable L11 cannot be simply shortened by disposing the first and second connectors C11 and C21 close to each other, and the total length needs to be secured to such an extent that the bending radius can be secured.

Therefore, when the first and second connectors C11 and C21 are disposed excessively close to each other, the first cable L11 is excessively lengthened with respect to the separation distance between the first and second connectors C11 and C21. An excessive portion thereof is disposed in disorder inside the housing 4. Consequently, there is a possibility that the first cable L11 interferes with a coupling work (insertion and removal work) of the other cables. In addition, the first cable L11 is excessively lengthened with respect to the separation distance between the first and second connectors C11 and C21. Accordingly, the first cable L11 is likely to vibrate, and the first cable L11 comes into contact with a surrounding substrate or the like due to the vibration, thereby creating a possibility that an electrical adverse effect occurs. In order to solve this problem, the first cable L11 may be fixed to a surrounding structure by a tie wrap or the like, but the coupling work of the first cable L11 becomes complicated as a fixing work is added.

In contrast, as in the present embodiment, when the first and second connectors C11 and C21 are disposed to be shifted in the width direction, the bending radius can be sufficiently secured without excessively increasing the length of the first cable L11 with respect to the separation distance between the first and second connectors C11 and C21. That is, a difference between the length of the first cable L11 and the separation distance between the first and second connectors C11 and C21 can be minimized, compared to the above-described configuration, and a possibility that the first cable L11 interferes with the coupling work of the other cables can be reduced. Furthermore, the first cable L11 is less likely to vibrate, and a possibility that an electrical adverse effect occurs can be reduced when the first cable L11 comes into contact with the surrounding substrate or the like due to the vibration. For this reason, the assembly workability and the maintenance workability of the controller 3 are improved.

Here, as illustrated in FIG. 4, in a plan view in the height direction, when a center-to-center distance along the width direction between the first connector C11 and the second connector C21 is defined as X and a center-to-center distance along the depth direction between the first connector C11 and the second connector C21 is defined as Y, it is preferable that a relationship of Y < X < 2Y is satisfied. In this way, the first and second connectors C11 and C21 are separated in the width direction rather than in the depth direction. Accordingly, each of the first and second connectors C11 and C21 is easily pinched, and the first cable L11 is easily inserted into and removed from the first and second connectors C11 and C21. In addition, the first and second connectors C11 and C21 are moderately separated from each other, and a surplus portion is less likely to be formed in the first cable L11. Therefore, the assembly workability and the maintenance workability of the controller 3 are further improved.

Furthermore, in a plan view in the height direction, when a length along the width direction of the first connector C11 is defined as β, it is preferable that a relationship of X > β is satisfied. Since this relationship is satisfied, the first connector C11 and the second connector C21 do not overlap each other in a plan view when viewed from the depth direction. Therefore, each of the first and second connectors C11 and C21 is easily pinched, and the first cable L11 is easily inserted into and removed from the first and second connectors C11 and C21. In addition, a coupling state between the first cable L11 and the first and second connectors C11 and C21 is easily visually recognized. Therefore, the assembly workability and the maintenance workability of the controller 3 are further improved. Furthermore, it is more preferable that a relationship of β < X < 3β is satisfied. In this manner, excessive separation between the first and second connectors C11 and C21 is suppressed, and the length of the first cable L11 can be suppressed.

Hitherto, a positional relationship between the first and second connectors C11 and C21 has been described. Similarly, the first and second connectors C12 and C22 are also disposed to be shifted in the width direction in a plan view in the height direction, and satisfy a relationship of Y < X < 2Y and X > β. Therefore, the assembly workability and the maintenance workability of the controller 3 are improved.

Here, whereas both the first and second connectors C11 and C21 extend along the width direction, in the first and second connectors C12 and C22, the first connector C12 extends along the depth direction, and the second connector C22 extends along the width direction. That is, extending directions of the first and second connectors C12 and C22 intersect with each other, and in particular, the extending directions are orthogonal to each other in the present embodiment. According to this configuration, twisting of the first cable L12 connecting the first and second connectors C12 and C22 can be suppressed while the separation distance between the first and second connectors C12 and C22 is moderately brought closer. The disposition of the first and second connectors C12 and C22 is not particularly limited, and for example, the extending directions of the first and second connectors C12 and C22 may intersect with each other at an angle other than 90°, or may be parallel to each other.

In addition, as illustrated in FIG. 4, in a plan view in the depth direction, the first connector C11 and the fourth connector C4 overlap each other, or the second connector C21 and the third connector C3 overlap each other. In particular, in the present embodiment, in a plan view in the depth direction, the first connector C11 and the fourth connector C4 overlap each other, and the second connector C21 and the third connector C3 overlap each other. According to this configuration, the third and fourth connectors C3 and C4 can be disposed in a space generated by disposing the first and second connectors C11 and C21 to be shifted in the width direction. Therefore, the space can be effectively utilized, and sizes of the power supply circuit substrate 51 and the system circuit substrate 53 can be reduced.

In addition, as illustrated in FIG. 4, in the controller 3, the second connectors C21 and C22 do not overlap the control circuit substrate 54 in a plan view in the height direction. According to this configuration, the second connectors C21 and C22 are not hidden behind the control circuit substrate 54 when viewed from an upper side. Therefore, the second connectors C21 and C22 can be easily visually recognized. Therefore, the first cables L11 and L12 can be easily inserted into and removed from the second connectors C21 and C22. In addition, a coupling state between the second connectors C21 and C22 and the first cables L11 and L12 can be easily visually recognized.

In addition, as illustrated in FIG. 3, in the controller 3, in a plan view in the height direction, each of the motor drive substrates 55 does not overlap the first connectors C11 and C12 and the second connectors C21 and C22. Furthermore, in the present embodiment, in a plan view in the height direction, each of the motor drive substrates 55 does not overlap the third, fourth, fifth, sixth, and seventh connectors C3, C4, C5, C6, and C7. According to this configuration, the cable can be easily inserted into and removed from the first, second, third, fourth, fifth, sixth, and seventh connectors C11, C12, C21, C22, C3, C4, C5, C6, and C7.

In particular, in the present embodiment, the motor drive substrate 55 is disposed closer to the second side surface panel 44 side, and the first, second, third, fourth, fifth, sixth, and seventh connectors C11, C12, C21, C22, C3, C4, C5, C6, and C7 are collectively disposed on the first side surface panel 43 side. Therefore, the motor drive substrate 55 is less likely to interfere with the cable when the cable is inserted into and removed from the first, second, third, fourth, fifth, sixth, and seventh connectors C11, C12, C21, C22, C3, C4, C5, C6, and C7. However, without being limited thereto, in a plan view in the height direction, at least one of the motor drive substrates 55 may overlap at least one of the first, second, third, fourth, fifth, sixth, and seventh connectors C11, C12, C21, C22, C3, C4, C5, C6, and C7.

In addition, as illustrated in FIG. 3, in the controller 3, in a plan view in the height direction, the first connectors C11 and C12 and the second connectors C21 and C22 do not overlap each of the electronic components 59 disposed on the power supply circuit substrate 51. In addition, in the present embodiment, in a plan view in the height direction, the third, fourth, fifth, sixth, and seventh connectors C3, C4, C5, C6, and C7 do not overlap each of the electronic components 59. According to this configuration, the cable can be easily inserted into and removed from the first, second, third, fourth, fifth, sixth, and seventh connectors C11, C12, C21, C22, C3, C4, C5, C6, and C7.

In addition, as illustrated in FIG. 4, in a plan view in the height direction, a first virtual straight line A11 connecting the centers of the first and second connectors C11 and C21 and a second virtual straight line A2 connecting the centers of the fifth and sixth connectors C5 and C6 do not intersect with each other. According to this configuration, the first cable L11 connecting the first and second connectors C11 and C21 and a cable (not illustrated) connecting the fifth and sixth connectors C5 and C6 are less likely to intersect with each other, and the assembly workability and the maintenance workability of the controller 3 are further improved. Similarly, in a plan view in the height direction, a first virtual straight line A12 connecting the centers of the first and second connectors C12 and C22 and a second virtual straight line A2 connecting the centers of the fifth and sixth connectors C5 and C6 do not intersect with each other. In this manner, the first cable L12 connecting the first and second connectors C12 and C22 and a cable (not illustrated) connecting the fifth and sixth connectors C5 and C6 are less likely to intersect with each other, and the assembly workability and the maintenance workability of the controller 3 are further improved. However, without being limited thereto, for example, at least one of the first virtual straight lines A11 and A12 may intersect with the second virtual straight line A2.

As illustrated in FIG. 4, in a plan view in the height direction, the first virtual straight line A11 connecting the centers of the first and second connectors C11 and C21 and the first virtual straight line A12 connecting the centers of the first and second connectors C12 and C22 do not intersect with each other. According to this configuration, the first cable L11 connecting the first and second connectors C11 and C21 and the first cable L12 connecting the first and second connectors C12 and C22 are less likely to intersect with each other, and the assembly workability and the maintenance workability of the controller 3 are further improved. In this way, the virtual straight lines connecting the connector provided on the power supply circuit substrate 51 and the connector provided on the system circuit substrate 53 which is a coupling partner of the connector do not intersect with each other. Therefore, as described above, the cables are less likely to intersect with each other, and the assembly workability and the maintenance workability of the controller 3 are further improved.

In addition, as illustrated in FIG. 3, in a plan view in the height direction, it is desirable that the virtual straight lines or the cables do not intersect with each other at least on the power supply circuit substrate 51 and the system circuit substrate 53.

In addition, as illustrated in FIG. 4, the power supply circuit substrate 51 is disposed in the vicinity of the first, third, and fifth connectors C11, C12, C3, and C5 disposed along the side 51a, and is supported by a leg 40 erected from the bottom surface panel 45. Therefore, bending deformation can be effectively suppressed in the power supply circuit substrate 51 when the cable is inserted into and removed from the first, third, and fifth connectors C11, C12, C3, and C5. Similarly, the system circuit substrate 53 is disposed in the vicinity of the second, fourth, sixth, and seventh connectors C21, C22, C4, C6, and C7 disposed along the side 53a, and is supported by the leg 40 erected from the bottom surface panel 45. Therefore, bending deformation can be effectively suppressed in the system circuit substrate 53 when the cable is inserted into and removed from the second, fourth, sixth, and seventh connectors C21, C22, C4, C6, and C7.

Hitherto, the disposition of the first, second, third, fourth, fifth, sixth, and seventh connectors C11, C12, C21, C22, C3, C4, C5, C6, and C7 has been described in detail. The controller 3 may include at least the first and second connectors C11 and C21 or the first and second connectors C12 and C22, and at least one of the third, fourth, fifth, sixth, and seventh connectors C3, C4, C5, C6, and C7 may be omitted. In addition, any other connector may be further provided.

Hitherto, the controller 3 has been described. As described above, in the controller 3 that controls the driving of the robot 2 on which the motors M1 to M4 are mounted, the controller 3 includes the housing 4 including the bottom surface panel 45, the power supply circuit substrate 51 including the first connectors C11 and C12, disposed on the bottom surface panel 45, converting the AC voltage into the DC voltage, and outputting the DC voltage, the system circuit substrate 53 including the second connectors C21 and C22, disposed on the bottom surface panel 45 by being aligned with the power supply circuit substrate 51 in the direction along the bottom surface panel 45, driven by the DC voltage input from the power supply circuit substrate 51, and generating the control signal for controlling the driving of the motors M1 to M4, and the first cables L11 and L12 coupled to the first connectors C11 and C12 and the second connectors C21 and C22 and electrically coupling the power supply circuit substrate 51 and the system circuit substrate 53. The first connectors C11 and C12 are disposed along the side 51a of the power supply circuit substrate 51 which faces the system circuit substrate 53, the second connectors C21 and C22 are disposed along the side 53a of the system circuit substrate 53 which faces the power supply circuit substrate 51, the first connector C11 and the second connector C21 are disposed to be shifted in the width direction, which is the second direction orthogonal to the depth direction, which is the first direction in which the power supply circuit substrate 51 and the system circuit substrate 53 are aligned, and the first connector C12 and the second connector C22 are disposed to be shifted in the width direction. According to this configuration, a surplus portion is less likely to be formed in the first cables L11 and L12, and the assembly workability and the maintenance workability of the controller 3 are improved.

In addition, as described above, the power supply circuit substrate 51 includes the third connector C3, and the system circuit substrate 53 includes the fourth connector C4. In a plan view in the depth direction, the first connector C11 and the fourth connector C4 overlap each other, or the second connector C21 and the third connector C3 overlap each other. According to this configuration, the third and fourth connectors C3 and C4 can be disposed in a space generated by disposing the first and second connectors C11 and C21 to be shifted in the width direction. Therefore, the space can be effectively utilized, and sizes of the power supply circuit substrate 51 and the system circuit substrate 53 can be reduced.

In addition, as described above, the controller 3 includes the control circuit substrate 54 disposed on the upper side of the system circuit substrate 53, and the second connectors C21 and C22 do not overlap the control circuit substrate 54 in a plan view of the bottom surface panel 45. According to this configuration, the second connectors C21 and C22 are not hidden behind the control circuit substrate 54 when viewed from an upper side. Therefore, the second connectors C21 and C22 can be easily visually recognized. Therefore, the first cables L11 and L12 can be easily inserted into and removed from the second connectors C21 and C22. In addition, a coupling state between the second connectors C21 and C22 and the first cables L11 and L12 can be easily visually recognized.

In addition, as described above, the controller 3 is installed in an erected state from the power supply circuit substrate 51 and the system circuit substrate 53, and includes the motor drive substrate 55 that generates the polyphase AC voltage which is a voltage to be input to the motors M1 to M4, based on the DC voltage input from the power supply circuit substrate 51 and the control signal input from the system circuit substrate 53. In a plan view of the bottom surface panel 45, the motor drive substrate 55 does not overlap the first connectors C11 and C12 and the second connectors C21 and C22. According to this configuration, the cable can be easily inserted into and removed from the first and second connectors C11, C12, C21, and C22.

In addition, as described above, the controller 3 includes the electronic component 59 disposed on the power supply circuit substrate 51. In a plan view of the bottom surface panel 45, each of the first connectors C11 and C12 and the second connectors C21 and C22 does not overlap the electronic components 59. According to this configuration, the cable can be easily inserted into and removed from the first and second connectors C11, C12, C21, and C22.

In addition, as described above, the power supply circuit substrate 51 includes the fifth connector C5, and the system circuit substrate 53 includes the sixth connector C6. In a plan view of the bottom surface panel 45, the first virtual straight lines A11 and A12 connecting the first connectors C11 and C12 and the second connectors C21 and C22, and the second virtual straight line A2 connecting the fifth connector C5 and the sixth connector C6 do not intersect with each other. In this manner, the first cables L11 and L12 and a cable (not illustrated) connecting the fifth and sixth connectors C5 and C6 are less likely to intersect with each other, and the assembly workability and the maintenance workability of the controller 3 are further improved.

In addition, as described above, in a plan view of the bottom surface panel 45, each of the first connector C12 and the second connector C22 has a long shape, and the extending direction of the first connector C12 and the extending direction of the second connector C22 intersect with each other. According to this configuration, twisting of the first cable L12 connecting the first and second connectors C12 and C22 can be suppressed while the separation distance between the first and second connectors C12 and C22 is moderately brought closer.

In addition, as described above, in a plan view of the bottom surface panel 45, when the center-to-center distance along the width direction between the first connectors C11 and C12 and the second connectors C21 and C22 is defined as X and the center-to-center distance along the depth direction between the first connectors C11 and C12 and the second connectors C21 and C22 is defined as Y, a relationship of Y < X < 2Y is satisfied. According to this configuration, each of the first connectors C11 and C12 and the second connectors C21 and C22 is easily pinched, and the first cables L11 and L12 can be easily inserted into and removed from the first connectors C11 and C12 and the second connectors C21 and C22. In addition, the first and second connectors C11 and C21 are moderately separated from each other, and the surplus portion is less likely to be formed in the first cable L11. The first and second connectors C12 and C22 are moderately separated from each other, and the surplus portion is less likely to be formed in the first cable L12. Therefore, the assembly workability and the maintenance workability of the controller 3 are further improved.

In addition, as described above, in a plan view of the bottom surface panel 45, when the length along the width direction of the first connectors C11 and C12 is defined as β, a relationship of X > β is satisfied. Since this relationship is satisfied, in a plan view when viewed from the depth direction, the first connector C11 and the second connector C21 do not overlap each other, and the first connector C12 and the second connector C22 do not overlap each other. Therefore, each of the first and second connectors C11, C12, C21, and C22 is easily pinched, and the first cables L11 and L12 is easily inserted into and removed from the first and second connectors C11, C12, C21, and C22. In addition, a coupling state between the first cables L11 and L12 and the first and second connectors C11, C12, C21, and C22 is easily visually recognized. Therefore, the assembly workability and the maintenance workability of the controller 3 are further improved.

Hitherto, the controller of the present disclosure has been described with reference to the illustrated embodiment. Meanwhile, the present disclosure is not limited thereto, and the configuration of each portion can be replaced with any configuration having the same function. In addition, any other configuration may be added to the present disclosure.

The first and second connectors C11 and C21 coupled to each other by the first cable L11 are disposed to be shifted in the width direction in a plan view in the height direction. In other words, the first and second connectors C11 and C21 do not overlap each other in a plan view in the depth direction. Although described above in this way, the description "being shifted" is not limited thereto, and includes that the first connectors C11 and C12 do not overlap by half or more of the length β along the width direction.

## Claims

1. A controller that controls driving of a robot on which a motor is mounted, the controller comprising:
a housing including a bottom surface panel;
a power supply circuit substrate including a first connector, disposed on the bottom surface panel, converting an AC voltage into a DC voltage, and outputting the DC voltage;
a system circuit substrate including a second connector, disposed on the bottom surface panel by being aligned with the power supply circuit substrate in a direction along the bottom surface panel, driven by the DC voltage input from the power supply circuit substrate, and generating a control signal for controlling driving of the motor; and
a first cable coupled to the first connector and the second connector and electrically coupling the power supply circuit substrate and the system circuit substrate, wherein
the first connector is disposed along a side of the power supply circuit substrate which faces the system circuit substrate,
the second connector is disposed along a side of the system circuit substrate which faces the power supply circuit substrate, and
the first connector and the second connector are disposed to be shifted in a second direction orthogonal to a first direction in which the power supply circuit substrate and the system circuit substrate are aligned.

2. The controller according to claim 1, wherein
the power supply circuit substrate includes a third connector,
the system circuit substrate includes a fourth connector, and
in a plan view in the first direction, the first connector overlaps the fourth connector, or the second connector overlaps the third connector.

3. The controller according to claim 1, further comprising:
a control circuit substrate disposed on an upper side of the system circuit substrate, wherein
in a plan view of the bottom surface panel, the second connector does not overlap the control circuit substrate.

4. The controller according to claim 1, further comprising:
a motor drive substrate installed in an erected state from the power supply circuit substrate and the system circuit substrate, and generating a voltage to be input to the motor, based on the DC voltage input from the power supply circuit substrate and the control signal input from the system circuit substrate, wherein
in a plan view of the bottom surface panel, the motor drive substrate does not overlap the first connector and the second connector.

5. The controller according to claim 1, further comprising:
an electronic component disposed on the power supply circuit substrate, wherein
in a plan view of the bottom surface panel, each of the first connector and the second connector does not overlap the electronic component.

6. The controller according to claim 1, wherein
the power supply circuit substrate includes a fifth connector,
the system circuit substrate includes a sixth connector, and
in a plan view of the bottom surface panel, a first virtual straight line connecting the first connector and the second connector does not intersect with a second virtual straight line connecting the fifth connector and the sixth connector.

7. The controller according to claim 1, wherein
in a plan view of the bottom surface panel, each of the first connector and the second connector has a long shape, and
an extending direction of the first connector intersects with an extending direction of the second connector.

8. The controller according to claim 1, wherein
in a plan view of the bottom surface panel, when a center-to-center distance between the first connector and the second connector along the second direction is defined as X, and a center-to-center distance between the first connector and the second connector along the first direction is defined as Y, a relationship of Y < X < 2Y is satisfied.

9. The controller according to claim 8, wherein
in a plan view of the bottom surface panel, when a length of the first connector along the second direction is defined as β, a relationship of X > β is satisfied.
